(19) Europäisches Patentamt
European Patent Office
Office européen des brevets

(11) **EP 1 415 337 B1**

(12) **EUROPEAN PATENT SPECIFICATION**

(45) Date of publication and mention
of the grant of the patent:
**18.11.2009 Bulletin 2009/47**

(51) Int Cl.:
*H01L 21/8238* (2006.01)    *H01L 27/092* (2006.01)

(21) Application number: **02761307.4**

(22) Date of filing: **09.08.2002**

(86) International application number:
**PCT/US2002/025286**

(87) International publication number:
**WO 2003/015160 (20.02.2003 Gazette 2003/08)**

(54) **DUAL LAYER CMOS DEVICES**

CMOS BAUELEMENTE MIT DOPPELTER SCHICHT

DISPOSITIFS CMOS A DEUX COUCHES

(84) Designated Contracting States:
**AT BE BG CH CY CZ DE DK EE ES FI FR GB GR IE IT LI LU MC NL PT SE SK TR**

(30) Priority: **09.08.2001 US 31188 P**

(43) Date of publication of application:
**06.05.2004 Bulletin 2004/19**

(73) Proprietor: **Amberwave Systems Corporation Salem, NH 03087 (US)**

(72) Inventor: **FITZGERALD, Eugene, A. Windham, NH 03087 (US)**

(74) Representative: **Belcher, Simon James et al Urquhart-Dykes & Lord LLP Tower North Central Merrion Way Leeds LS2 8PA (GB)**

(56) References cited:
**EP-A- 0 683 522     US-A- 5 155 571 US-A- 6 111 267**

• **YEE-CHIA YEO ET AL: "Enhanced performance in sub-100 nm CMOSFETs using strained epitaxial silicon-germanium" 2000, PISCATAWAY, NJ, USA, IEEE, USA , 10 December 2000 (2000-12-10), pages 753-756, XP010531871**

• **PATENT ABSTRACTS OF JAPAN vol. 2000, no. 23, 10 February 2001 (2001-02-10) -& JP 2001 168342 A (FUJITSU LTD), 22 June 2001 (2001-06-22)**
• **PATENT ABSTRACTS OF JAPAN vol. 1997, no. 12, 25 December 1997 (1997-12-25) -& JP 09 219524 A (TOSHIBA CORP), 19 August 1997 (1997-08-19)**
• **PATENT ABSTRACTS OF JAPAN vol. 2000, no. 23, 10 February 2001 (2001-02-10) -& JP 2001 160594 A (TOSHIBA CORP), 12 June 2001 (2001-06-12) -& US 6 339 232 B1 (TAKAGI SHINICHI) 15 January 2002 (2002-01-15)**
• **PATENT ABSTRACTS OF JAPAN vol. 2000, no. 04, 31 August 2000 (2000-08-31) -& JP 2000 021783 A (TOSHIBA CORP), 21 January 2000 (2000-01-21) -& US 6 407 406 B1 (TEZUKA TSUTOMU) 18 June 2002 (2002-06-18)**
• **MIZUNO T ET AL: "ADVANCED SOI-MOSFETS WITH STRAINED-SI CHANNEL FOR HIGH SPEED CMOS -ELECTRON/HOLE MOBILITY ENHANCEMENT-" 2000 SYMPOSIUM ON VLSI TECHNOLOGY. DIGEST OF TECHNICAL PAPERS. HONOLULU, JUNE 13-15, 2000, SYMPOSIUM ON VLSI TECHNOLOGY, NEW YORK, NY: IEEE, US, 13 June 2000 (2000-06-13), pages 210-211, XP000970820 ISBN: 0-7803-6306-X**

**Description**

TECHNICAL FIELD

The invention generally relates to semiconductor devices, and, more particularly, to the fabrication and structure of devices that include metal-oxide-semiconductor type components.

RELATED APPLICATIONS

This application claims benefit of and priority to U.S. Provisional Patent Application Serial No. 60/311,188, filed August 9, 2001.

BACKGROUND INFORMATION

Newer types of substrates can be used as replacements for traditional silicon wafers to improve silicon-based electronic device performance. For example, wafers that have a silicon-germanium (SiGe) alloy layer can provide improved channel-layer performance in a strained-silicon layer grown on a relaxed, i.e., relatively strain-free, SiGe layer. Strained silicon can provide improved minority carrier mobility for a surface-channel layer in, for example, metal-oxide-semiconductor (MOS) field-effect transistors (FET).

The carrier mobility of the silicon channel layer generally increases with the level of strain in the layer. The level of strain is determined by the lattice mismatch with the underlying relaxed SiGe layer. The lattice mismatch, in turn, is determined by the Ge concentration of the relaxed SiGe layer. That is, the lattice spacing of a relaxed SiGe layer generally increases with increasing Ge concentration.

Thus, as the Ge concentration in a relaxed SiGe substrate layer is increased, the electron mobility in the overlying strained-silicon channel layer generally increases. The electron mobility generally saturates beyond a Ge concentration of approximately 20 atomic %, but the hole mobility continues to increase as the Ge concentration rises.

The behavior of electron and hole mobility is of particular significance, for example, in the performance of an inverter, one of the basic building blocks of integrated circuit devices. An inverter includes both an NMOS (i.e., n-channel) and PMOS (i.e., p-channel) transistor, and the inverter delay is dependent upon both the NMOS and PMOS transistor drive currents. With mobility enhancements of the electron and hole charge carriers, the drive current increases, and the inverter stage delay decreases.

An inverter delay is a function of both the NMOS and PMOS device transconductance. The delay can be described as:

$$t_p \approx \frac{C_L}{2}\left(\frac{1}{K_p}+\frac{1}{K_n}\right)$$

where $K_i = Cv_{sat}C_{ox}W_i$, "i" represents p or n, and $t_p$ is the total inverter delay time. The delay is related to the ability of the NMOS and PMOS transistors to drive the inverter capacitance, $C_L$. $K_p$ and $K_n$ are, respectively, related to the transconductance of the PMOS and NMOS transistors. C is a constant, $v_{sat}$ is the saturation velocity of the carrier in the channel, $C_{ox}$ is the gate capacitance per unit area, and $W_i$ is the width of the corresponding NMOS or PMOS transistor (i.e., the width of the gate).

The NMOS and PMOS transistors of a conventional Si inverter can be designed to provide approximately equal driving capabilities by appropriately adjusting the widths of the devices. In this case, the following expression aids in an estimate of improvement in inverter performance:

$$t_p \approx \frac{B}{2}\left(\frac{1}{e_p\omega_p}+\frac{1}{e_n\omega_n}\right),$$

where B is a constant, ep is the enhancement factor in PMOS drive current due to channel improvement relative to a standard silicon component (e.g., through use of strained-silicon), $e_n$ is the enhancement factor in NMOS drive current, $\omega_p$ is any relative width change in the PMOS transistor (new width divided by the width of standard a standard silicon PMOS component in a reference standard inverter), and $\omega_n$ is any relative width change in the NMOS transistor. This expression is an approximation because any large change in device width can affect the constant B, which is associated with the overall inverter capacitance.

A standard Si inverter is typically optimized to minimize stage delay by widening the PMOS transistor in order to balance the current drive in the NMOS and PMOS transistors. This requirement arises because standard silicon devices have a much higher NMOS drive current than PMOS drive current (due to electrons having a much higher mobility than holes in unstrained silicon).

Strained silicon with 20 atomic % Ge on a relaxed SiGe substrate can increase electron mobility by approximately 80%, with a hole mobility at best only slightly enhanced. Thus, strained silicon can cause an increase in mobility mismatch, and, therefore, an increase in drive current mismatch between the NMOS and PMOS transistors in the inverter. Therefore, the inverter stage delay generally does not decrease by a full 80% when strained silicon is employed as a channel layer.

As the germanium concentration in a relaxed SiGe substrate rises to 30% and to 40%, the hole mobility increases, respectively, by approximately 40% and over 100%. Beyond a concentration of 40%, little or no further enhancement of the hole mobility occurs. At 40% Ge in the relaxed SiGe substrate, the ratio of the drive currents in the NMOS and PMOS transistors generally is nearly the same ratio as in a standard device.

Thus, asymmetrical motilities and transistor size remain a problem for inverters and other semiconductor devices.

A way to utilise strained SiGe layer for both, the NFET and the PFET is shown in Yee-Chia Yeo, Qiang Lu, Tsu-Jae King, Chenming Hu, Kawashima T., Oishi M., Mashiro S., Sakai J., "Enhanced performance in sub-100 nm CMOSFETs using strained epitaxial silicon-germanium", Electron Devices Meeting, 2000. IEDM Technical Digest. International December 10-13, 2000, Piscataway, NJ, USA,IEEE.

Mizuno T. et al, ("Advanced SOI-MOSFETs with strained Si channel for high speed CMOS electron/hole mobility enhancement", 2000 Symposium on VLSI technology, Honolulu, June 13-15, 2000, New York, NY, IEEE, US) demonstrates a way of utilising strained-SiGe and strained-Si layers for both, the NFET and the PFET.

SUMMARY OF THE INVENTION

The invention involves a structure corresponding to claim 1 and a fabrication method corresponding to claim 21 for semiconductor devices that include a channel layer having a dual-layer structure. The channel layer is preferably a shared surface-channel layer for more than one component in the device. The channel layer provides enhanced electron mobility and, in particular, enhanced hole mobility. The channel layer serves as a surface channel layer for both PMOS and NMOS components fabricated on a common substrate.

The dual-layer structure preferably includes a silicon layer that overlies and is preferably in contact with a $Si_{1-y}Ge_y$ or germanium layer. The silicon layer preferably is in contact with a gate dielectric.

Inverters, according to principles of the invention, can be fabricated with PMOS and NMOS transistors of similar size. The inverters can then consume less space on a substrate, in comparison to asymmetrical inverters. The inverters can have a stage delay that is decreased relative to other inverters.

Accordingly, in a first aspect, the invention features a semiconductor-based device, which includes a channel layer. The channel layer includes a distal layer and a proximal layer in contact with the distal layer. The distal layer supports at least a portion of hole conduction for at least one p-channel component. The proximal layer has a thickness that permits a hole wave function to effectively extend from the proximal layer into the distal layer to facilitate hole conduction by the distal layer. The proximal layer supports at least a portion of electron conduction for at least one n-channel component.

Each p-channel component can include a p-channel transistor, and each n-channel component can include an n-channel transistor. The components thus share a common channel layer, and can be operated as surface channel layer components. The n-channel transistor and the p-channel transistor can be associated with, for example, an inverter.

By enhancing hole mobility even more than electron mobility, inverters having transistors of a similar area size or having a similar dimension can be fabricated. For example, n-channel and p-channel transistors can be fabricated with similar gate lengths or gate widths.

The thickness of the proximal layer can be less for the p-channel component than for the n-channel component, to extend a greater portion of hole wave functions from the proximal layer into the distal layer.

The proximal layer is under tensile strain. This can be accomplished, for example, with a silicon proximal layer adjacent to a SiGe substrate layer.

The distal layer is preferably under compressive strain. This can be accomplished, for example, with a SiGe distal layer having a higher germanium concentration than an underlying SiGe substrate layer.

Alternatively, the proximal layer can be formed from silicon, and the thickness of the silicon layer can be in a range of approximately 4 nm to approximately 10 nm, preferably 5 nm, to support electron conduction within the proximal layer. The thickness of the distal layer can be in a range of approximately 5 nm to approximately 18 nm.

The device can also include a dielectric layer in contact with the proximal layer. The proximal layer is formed of strained silicon, and the distal layer formed of strained germanium or of strained SiGe alloy.

The device can further include a relaxed SiGe substrate layer in contact with the distal layer, the relaxed SiGe layer having a germanium concentration in a range of approximately 30 atomic % to approximately 85 atomic %.

In a second aspect, the invention features a method for fabricating a semiconductor-based device. The method includes provision of a distal portion of a channel layer, and provision of a proximal portion of the channel layer, the proximal portion being in contact with the distal portion.

Provision of the proximal portion can include thinning the proximal portion in a location of each p-channel component to enhance the support of hole conduction. Thinning can include reducing the thickness of the proximal layer in the location of each p-channel component while leaving the thickness substantially unchanged in a location of at least one n-channel component.

BRIEF DESCRIPTION OF THE DRAWINGS

In the drawings, like reference characters generally refer to the same parts throughout the different views. Also, the drawings are not necessarily to scale, emphasis instead generally being placed upon illustrating the principles of the invention.

FIG. 1 is cross-sectional view of a portion of an embodiment of a semiconductor-based device.

FIG. 2A is a band diagram that illustrates the behavior of electrons for an illustrative NMOS component implementation of the embodiment of FIG. 1.

FIG. 2B is a band diagram that illustrates the behavior of holes for an illustrative PMOS component implementation of the embodiment of FIG. 1.

FIG. 3 is a cross-sectional view of an embodiment of a transistor that can be included in a device, according to principles of the invention.

FIG. 4 is a cross-sectional view of an embodiment of a device that includes a PMOS transistor and a NMOS transistor.

FIG. 5 is a graph of inverter stage delay as a function of gate length data, associated with seven illustrative inverters.

DESCRIPTION

The invention provides improved semiconductor device designs, for example, improved inverter design. Various features of the invention are well suited to applications utilizing MOS transistors that include, for example, Si, $Si_{1-x}Ge_x$ and/or Ge layers in and or on a substrate.

The term "MOS" is here used to refer generally to semiconductor devices that include a conductive gate spaced at least by an insulting layer from a semiconducting channel layer. The terms "SiGe" and" $Si_{1-x}Ge_x$" are here used interchangeably to refer to silicon-germanium alloys. The term "silicide" is here used to refer to a reaction product of a metal, silicon, and optionally other components, such as germanium. The term "silicide" is also used, less formally, to refer to the reaction product of a metal with an elemental semiconductor, a compound semiconductor or an alloy semiconductor.

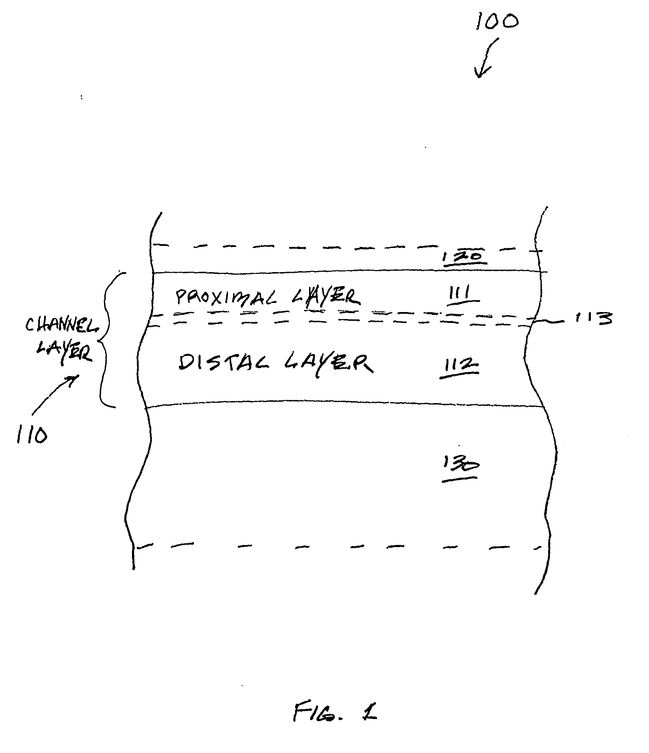

First, with reference to FIG. 1, some general principles of the invention are described in broad overview. FIG. 1 is a cross-sectional view of a portion of a semiconductor-based device 100. The device 100 includes a channel layer 110, which is a surface channel layer (i.e., in contact with a dielectric layer). The channel layer 110 includes a proximal layer 111 and a distal layer 112.

The distal layer 112 and the proximal layer 111 are in contact with each other. Further, the proximal layer 111 is preferably in contact with a dielectric layer 120.

The channel layer 110 further, and optionally, is in contact with a substrate layer 130. The substrate layer 130, such as a relaxed SiGe layer, can control, in part, the level of strain in the distal layer 112 and the proximal layer 111.

The channel layer 110 provides both an n-channel for at least one NMOS component and a p-channel for at least one PMOS component. The components can be MOS transistors, for example, NMOS and PMOS transistors in an inverter, sharing the same surface channel layer. The channel layer 110 provides a dual channel via appropriate selection, in part, of layer thicknesses and compositions.

Although principles of the invention can be applied to devices fabricated from a wide variety of materials, including a wide variety of semiconductor materials, for simplicity, the following description will focus on embodiments that include silicon, germanium and SiGe alloys.

In the implementation of the device **100,** the proximal layer **111** is a silicon layer under a tensile strain, the distal layer **112** is a germanium or $Si_{1-y}Ge_y$ layer under a compressive strain, and the distal layer **112** is in contact with the substrate layer **130.** The substrate layer **130** includes a relaxed $Si_{1-x}Ge_x$ layer having a lower concentration of germanium than that of the distal layer **112.** Thus strain in the proximal layer **111** is largely determined by the concentration of germanium in the relaxed $Si_{1-x}Ge_x$ layer, while the strain in the distal layer **112** is largely determined by the difference in germanium concentration between the distal layer **112** and the relaxed $Si_{1-x}Ge_x$ substrate layer **130.**

The proximal layer **111** preferably has a thickness minimally sufficient to support electron conduction, that is, to provide an n-channel for one or more NMOS components. For a silicon layer of the presently described implementation, the silicon thickness is approximately 5 nm.

For silicon thicknesses less than approximately 4 nm, some loss of electron mobility will generally occur. Hole mobility in the channel layer **110,** however, generally benefits from reduction in the thickness of the proximal layer **111.** The wave function of a hole, perpendicular to the channel layer **110** interfaces, is relatively large due to a relatively small mass of holes in this direction. Thus, in the case of a silicon proximal layer **111,** a hole wave function generally extends well beyond the silicon proximal layer **111** into the underlying distal layer **112.**

The channel layer **110** then provides an enhanced hole mobility, in part due to the enhanced hole mobility provided by the compressive germanium or $Si_{1-y}Ge_y$ distal layer. The distal layer **112,** in this implementation, has a band-gap offset relative to both the proximal layer **111** and the relaxed SiGe substrate layer **130,** which can promote confinement of the extended hole wave function within the compressed distal layer **112.** This effect can further promote enhanced hole mobility for a p-channel component in the device **100.**

The above-described implementation provides enhanced hole mobility via a number of means. For example, a compressively strained $Si_{1-y}Ge_y$ layer has a greater hole mobility than an unstrained $Si_{1-y}Ge_y$ layer. A greater Ge concentration can also enhance hole mobility.

Further, this implementation can reduce loss of mobility due to scattering of holes at the interface between the dielectric layer **120** and the proximal layer **111.** For example, an enhancement-mode surface-channel MOS transistor, as known in the semiconductor arts, forces carriers to traverse the transistor channel while very close to the gate dielectric interface. Such a transistor, when implemented according to principles of the invention, can provide reduced hole scattering due, at least in part, to extension of the hole wave functions beyond the very thin proximal layer **111.**

Although the mobility of holes in the distal layer **112** will generally be greater than that in the proximal layer **111,** a strained-silicon proximal layer **111** can still provide hole mobility that is enhanced relative to a conventional silicon surface-channel component. Thus, the combined proximal and distal layers **111, 112** can serve to provide highly enhanced hole mobility for p-channel components, while providing enhanced electron mobility for n-channel components.

The electron mass in the vertical direction, i.e., the surface normal direction, is relatively large in strained silicon. Thus, the electron wave function is relatively small in this direction, in comparison to the relatively large wave function for holes. Hence, electrons can be substantially confined within a relatively very thin layer. As indicated above, a strained-silicon layer of approximately 5 nm thickness can support substantially the entire wave function of an electron, while permitting a large portion of a hole wave function to extend beyond the strained-silicon layer.

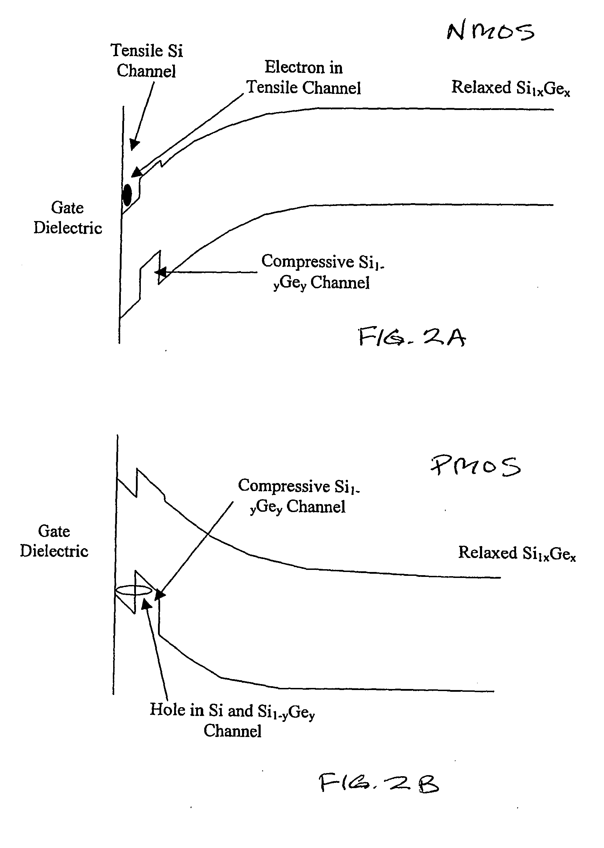

**FIGS. 2A** and **2B** show band diagrams, which illustrate the behavior of electrons and holes for the implementation described above. **FIG. 2A** illustrates a NMOS component and **FIG. 2B** illustrates a PMOS component, for embodiments with a tensile silicon proximal layer **111** and with a compressive $Si_{1-y}Ge_y$ distal layer **112.** For the NMOS component, the diagram illustrates the confinement of electrons substantially within the proximal layer **111.** For the PMOS component, the diagram illustrates the distribution of holes between the proximal layer **111** and the distal layer **112.**

As described above, a strained-silicon proximal layer **111** having a thickness of approximately 5 nm can provide a good balance between the tradeoffs of electron confinement within the proximal layer **111** and extension of hole wave function into the distal layer **112.** Thicknesses and compositions of layers in some embodiments that utilize silicon and germanium are described next.

In one implementation, the distal layer **112** is essentially 100 % germanium. The thickness of the distal layer **112** is preferably in a range of approximately 5 nm to approximately 18 nm. The distal layer **112** is in contact with a substrate layer **130** of relaxed SiGe having a concentration preferably in a range of approximately 60 atomic % Ge to approximately 80 atomic % germanium. This composition can provide an effective level of compressive strain in the distal layer **112** while the germanium concentration in the distal layer **112** (i.e., 100 %) further improves hole mobility.

An implementation having a distal layer **112** of germanium, as just described, can lead to stresses in a proximal layer **111** of silicon that will lead to partial or complete relaxation of the silicon. This is so because a pure germanium distal layer **112** is preferably formed on a substrate layer **130** having a relatively high concentration of germanium; the high concentration substrate layer **130** will generally have a relatively very high lattice mismatch relative to the silicon of the proximal layer **111.**

Reduction in the concentration of germanium in the substrate layer **130,** and related reduction of germanium in the distal layer **112** can substantially reduce or eliminate relaxation of the proximal layer **111.** Thus, a relatively high level of tensile stress in the proximal layer **111** can be maintained.

For example, a substrate layer **130** of relaxed SiGe having a composition of approximately 40 atomic % Ge can be used in combination with a distal layer **112** having a composition in a range of approximately 60 atomic % Ge to approximately 80 atomic % germanium. Reduced stress in a silicon proximal layer **111** due to this implementation can preserve the benefits of a tensily strained silicon layer.

As another alternative, the proximal layer **111** can be reduced in thickness when used in combination with a substrate layer **130** having a relatively large lattice mismatch that will cause a correspondingly large stress in the proximal layer **111.** Thus, some thickness of the proximal layer **111** can be sacrificed to preserve a tensile strain in the proximal layer **111.**

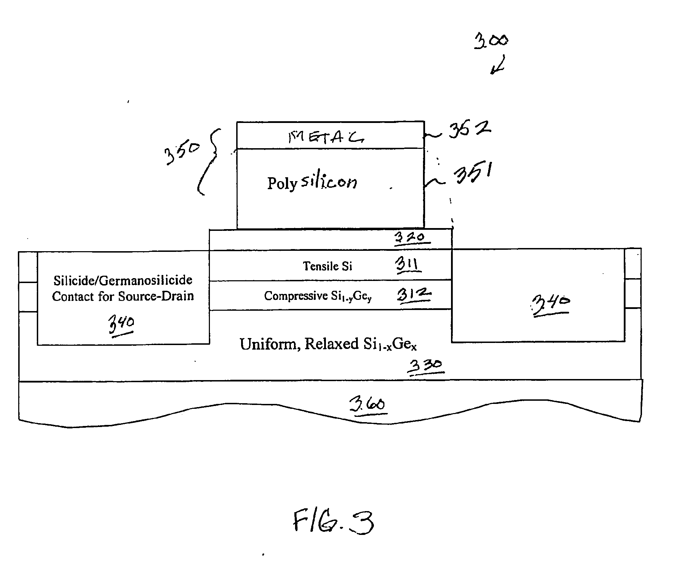

**FIG. 3** is a cross-sectional view of an embodiment of a transistor **300** that can be included in a device, according to principles of the invention. The transistor **300** includes a gate contact **350,** source and drain silicide contacts **340,** a gate oxide layer **320,** a channel layer (shared with other components in the device) including a tensile-silicon proximal layer **311** and a compressive $Si_{1-y}Ge_y$ distal layer **312,** a relaxed $Si_{1-x}Ge_x$ substrate layer **330,** and a silicon substrate **360.** The gate contact **350** can include a doped conductive polycrystalline silicon ("polysilicon") lower portion **351** proximal to the gate oxide **320** and a gate silicide upper portion **352.**

The tensile silicon proximal layer **311** and the compressive $Si_{1-y}Ge_y$ distal layer **312** can be epitaxially grown on the relaxed $Si_{1-x}Ge_x$ layer **330.** These layers provide a channel layer for the transistor **300.** The source and drain contacts **340** can be formed, for example, by depositing a metal layer and reacting the metal layer with the channel layer and the relaxed SiGe layer **360.**

The gate oxide **320** is formed on the proximal layer **311,** possibly consuming a portion of the surface of the strained silicon. The dielectric layer **320** can be formed by various methods conventional in the art, e.g., thermal oxidation or a deposition technique.

The gate oxide **320** can be, for example, a 1.5 to 10.0 nm thick layer of silicon dioxide. Other embodiments include other suitable dielectric materials, e.g., silicon oxynitride, silicon nitride, a plurality of silicon nitride and silicon oxide layers, or a high-k dielectric.

The transistor **300,** according to principles of the invention, can be implemented as a NMOS or a PMOS component. The transistor **300** can include, for example, different doping types and levels in the channel layer. A device can thus include NMOS and PMOS transistors **300,** utilizing a common channel layer, and both NMOS and PMOS components can provide improved surface channel transistor performance.

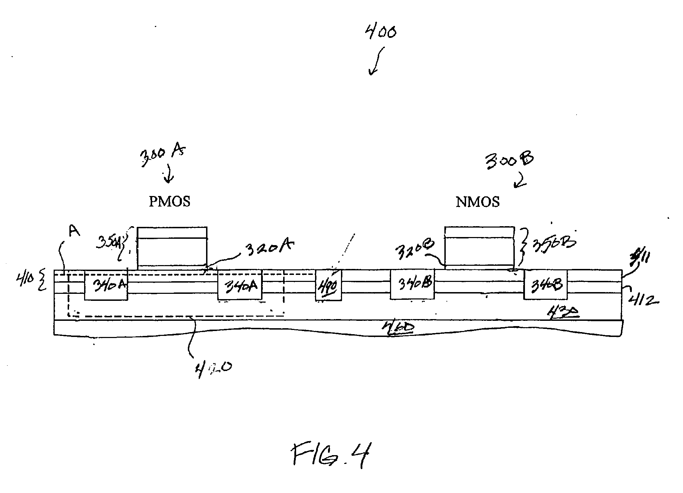

Referring now to **FIG. 4,** features of the invention that permit improved inverters are described. **FIG. 4** is a cross-sectional view of a device **400** that includes a PMOS transistor **300A** and a NMOS transistor **300B.** The transistors **300A, 300B** have structures and compositions similar to the embodiment described with respect to **FIG. 3.**

The transistors **300A, 300B** include gate contacts **350A, 350B,** source and drain silicide contacts **340A, 340B,** and gate oxide portions **320A, 320B.** The transistors **300A, 300B** share a channel layer **410** that includes a tensile silicon proximal layer **411** and a compressive $Si_{1-y}Ge_y$ distal layer **412.** The transistors **300A, 300B** also share a relaxed $Si_{1-x}Ge_x$ substrate layer **430** and a silicon substrate **360.**

The device includes an n-type implanted dopant well **420,** within which the PMOS transistor **300A** resides. The dopant well **420** can be formed via any of a variety of methods known in the semiconductor fabrication arts. The transistors **300A, 300B** are electrically isolated from each other via a shallow trench isolation (STI) portion **490.**

The isolation **490** preferably is deep enough to cross the channel layer **410,** ending at least in the SiGe relaxed substrate layer **430.** In other embodiments, the isolation **490** is absent or replaced by other isolation means. For example, one embodiment includes semi-recessed oxide isolation (S-ROX) portions.

In an alternative implementation of the device **400,** the proximal layer **411** in the vicinity of the PMOS transistor **300A** is thinned prior to formation of the gate oxide portions **320A.** The thinned proximal layer **411** is indicated by the dashed line **A** in **FIG. 4.** This alternative can provide a further enhancement of the hole mobility in the channel layer **410** for the PMOS transistor **300A.**

Some benefits of the invention when applied to inverter fabrication are described below, with a few illustrative embodiments.

**Table I**

| Row | $\omega_n$, | $\omega_p$ | $e_n$ | $e_p$ | Relative $t_p$ |
|---|---|---|---|---|---|
| 1 | 1 | 1 | 1 | 1 | 1 |
| 2 | 1 | 1 | 1.8 | 1 | 0.78 |
| 3 | 1 | 1 | 1.8 | 1.8 | 0.56 |
| 4 | 1 | 1 | 1.8 | 7 | 0.35 |

(continued)

| Row | $\omega_n$, | $\omega_p$ | $e_n$ | $e_p$ | Relative $t_p$ |
|---|---|---|---|---|---|
| 5 | 2 | 1 | 1.8 | 7 | 0.21 |
| 6 | 2 | 1 | 2.17 | 7 | 0.19 |
| 7 | 2 | 1.17 | 2.17 | 7 | 0.176 |

**Table I,** above, lists values of relative inverter stage delay ($t_p$) as a function of transistor parameters for seven illustrative inverters. The parameters include: $e_n$ and $e_p$, the enhancement factors, respectively, for the NMOS and PMOS transistor drive currents; $\omega_p$, the relative width change of the PMOS transistor (i.e., PMOS transistor width of an illustrative transistor divided by the width of a standard PMOS transistor of a standard reference inverter); and $\omega_n$, the relative width change of the NMOS transistor of an illustrative inverter.

As shown in the listed examples, inverter stage delay can be reduced to increase inverter performance without decreasing transistor gate length. **Table I** illustrates the effect of drive current enhancements as well as adjustments of device width on the relative decrease in inverter delay time.

The first row represents a standard reference inverter (that is, no delay decrease). The second row represents an inverter having a strained-silicon channel directly on a relaxed $Si_{0.8}Ge_{0.2}$ substrate. In this case, the electron enhancement factor is 1.8, with the assumption that the hole enhancement has approximately disappeared during processing, leaving an $e_p$ of 1. The delay for this inverter is reduced by a factor of 0.78 relative to the reference inverter.

The third row illustrates an inverter having a strained-silicon layer directly on a relaxed $Si_{0.6}Ge_{0.4}$ substrate. The hole mobility enhancement in the example PMOS component is 1.8.

Further, in this example, the electron and hole enhancements have been selected to be the same. This example inverter design can be particularly advantageous for porting legacy digital circuit designs, since the ratio of NMOS and PMOS mobility has not changed from that of conventional silicon-based inverters.

The fourth row is representative of an inverter in which the NMOS and PMOS transistors include a compressive Ge distal layer and a silicon proximal layer, according to principles of the invention. In this case, the hole enhancement can be, for example, as high as approximately 7. Both the NMOS and PMOS devices have very high carrier mobilities, and the mobilities are approximately the same.

In the fifth row, the illustrative inverter has NMOS and PMOS transistors that are symmetric, i.e., the transitors have the same drive current by adjusting the NMOS component gate width by a factor of approximately 2.

In the sixth row, the illustrative inverter has a silicon proximal layer that has been thinned for both the PMOS and NMOS transistors, and which resides on a compressive germanium distal layer; the electron wave function, as well as the hole wave function, is predominately located in the compressed Ge layer.

In the final row, i.e., the seventh, the PMOS transistor width has been adjusted to make the transistor currents symmetrical.

As illustrated by **Table I,** application of features of the invention to inverter design can reduce inverter delay by up to 82% or more. Thus, for example, digital circuit performance can be greatly improved without resorting to decreases in transistor gate length.

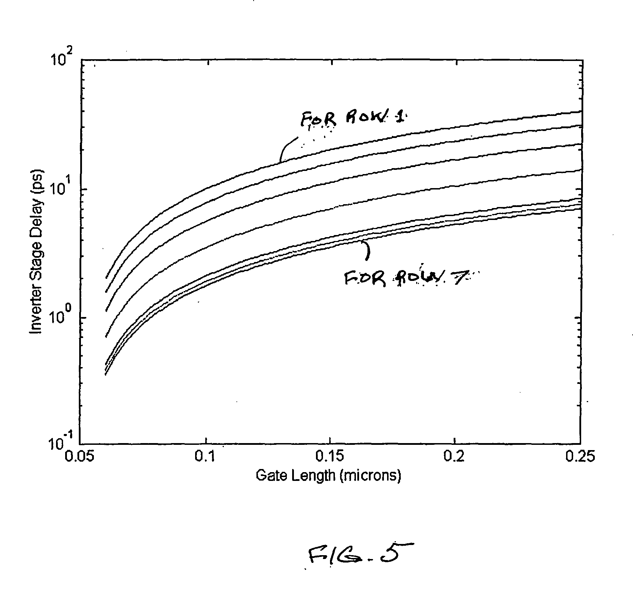

**FIG. 5** illustrates inverter stage delay as a function of gate length variations, associated with the seven illustrative inverters of **Table** I. The top curve (the conventional, and slowest, inverter) corresponds to the first row of **Table I.** As illustrated, inverters that include dual-channel layers, i.e., a channel layer having a proximal layer and a distal layer according to principles of the invention, can provide performance improvement without reducing device feature dimensions.

As indicated above, some embodiments of the invention utilize a substrate that includes a SiGe substrate layer. The SiGe substrate layer can be grown on a silicon wafer, and can include more than one layer of alloys of varying composition, thickness and growth conditions. Thus, the substrate layer can include a SiGe layer or multiple SiGe layers and/or SiGe layers having a graded composition. In some embodiments, the SiGe layer includes a relaxed SiGe layer grown on intermediate SiGe layers that accommodate the lattice mismatch with a silicon wafer.

The substrate can include, for example, a silicon wafer, with the SiGe layers grown on the silicon wafer. In this case, an oxide layer can be present between the silicon wafer and the SiGe layer. Other types of materials can provide a base or substrate, e.g., silicon-on-insulator (SOI) wafers, germanium wafers, glass substrates and laminated substrates.

Silicon, germanium and SiGe layers can be formed, for example, via known epitaxial growth techniques. Growth of silicon, germanium or SiGe layers of suitable composition and thickness on a SiGe relaxed layer, enables production of a channel layer of controlled stress and dislocation density. Examples of SiGe substrates, in which the Ge content can be up to 100%, include: a relaxed, uniform composition SiGe layer on a graded composition SiGe layer atop a Si substrate; a relaxed, uniform composition SiGe layer directly adjacent to a Si substrate; and a relaxed, uniform composition SiGe layer on an insulating layer like $SiO_2$, adjacent a Si substrate.

**Claims**

1. A semiconductor-based device, comprising:

   a substrate, and
   a channel layer (410) which overlies and is in contact with the substrate, and which is shared by at least one p-channel component (300A) and at least one n,-channel component (300B), comprising:

   a distal layer (412) to support at least a portion of hole conduction for the at least one p-channel component; and
   a proximal layer (411) to support at least a portion of an electron current for the at least one n-channel component, the proximal layer being in contact with the distal layer with the distal layer located between the substrate and the proximal layer, and having a thickness which permits a hole wave function to extend effectively from the proximal layer into the distal layer to facilitate hole conduction by the distal layer;

   in which the proximal layer is under tensile strain.

2. The device of claim 1, wherein the at least one p-ehanel component comprises a p-channel transistor, the at least one n-channel component comprises an n-channel transistor.

3. The device of claim 2, wherein the n-channel transistor and the p-channel transistor are associated with an inverter.

4. The device of claim 3, wherein a gate width of the n-channel transistor and a gate width of the p-channel transistor are the same.

5. The device of claim 3, wherein a gate length of the n-channel transistor and a gate length of the p-channel transistor are the same.

6. The device of claim 3, wherein a hole mobility of the p-channel transistor and an electron mobility of the n-channel transistor are the same.

7. The device of claim 1, wherein the thickness of the proximal layer is less for the p-channel component than for the n-channel component.

8. The device of claim 1, wherein the proximal layer consists of silicon, and the thickness of the proximal layer is in a range of 4 nm to 10 nm.

9. The device of claim 8, wherein the thickness of the proximal layer is approximately 5 nm.

10. The device of claim 8, wherein the thickness of the distal layer is in a range of 5 nm to 18 nm.

11. The device of claim 1, wherein the proximal layer supports all of an electron current for at least one n-channel component.

12. The device of claim 1, wherein the distal layer supports at least a portion of an electron current for at least one n-channel component.

13. The device of claim 12, wherein the thickness of the proximal layer is less than approximately 5 nm.

14. The device of claim 1, further comprising a dielectric layer in contact with the proximal layer, the proximal layer being located between the dielectric layer and the distal layer.

15. The device of claim 1, wherein the proximal layer consists essentially of silicon, and the distal layer consists of germanium.

16. The device of claim 15, further comprising a relaxed SiGe layer in contact with the distal layer, the relaxed SiGe layer having a germanium concentration in a range of 60 atomic % to 85 atomic %.

17. The device of claim 1, wherein the proximal layer consists essentially of silicon, and the distal layer consists of silicon and germanium.

18. The device of claim 1 , further comprising a relaxed SiGe layer in contact with the distal layer, the relaxed SiGe layer having a germanium concentration in a range of 30 atomic % to 50 atomic %, and wherein the distal layer has a germanium concentration in a range of 55 atomic % to 85 atomic %.

19. The device of claim 1, wherein the distal layer is under compressive strain.

20. The device of claim 19, further comprising a relaxed SiGe layer in contact with the distal layer, wherein the distal layer has a greater concentration of germanium than a concentration of germanium in the relaxed SiGe layer.

21. A method for fabricating a semiconductor-based device, the method comprising:

   providing on a substrate (430) a distal portion (412) of a channel layer (410) to support hole conduction for at least one p-channel component (300A); and
   providing a proximal portion (411) of the channel layer (410), proximal portion (411) being in contact with the distal portion (412) of the channel layer (410) between the substrate (430) and the proximal portion (411), and having a thickness that, permits a hole wave function to effectively extend from the proximal portion (411) into the distal portion (412) to facilitate hole conduction by the distal portion;

   in which the channel layer (410) is shared by the at least one p-channel component (300A) and the at least one n-channel component (300B) and in which the proximal portion (411) is under tensile strain.

22. The method of claim 21, wherein providing the proximal portion comprises thinning the proximal portion in a location of the at least one p-channel component to enhance the support of hole conduction.

23. The method of claim 22, wherein thinning comprises reducing the thickness of the proximal in the location of the at least one p-channel component while leaving the thickness unchanged in a location of at least one n-channel component.

24. The method of claim 21, further comprising providing a substrate layer comprising silicon and germanium, and wherein the proximal portion comprises tensilely strained silicon, and the distal portion comprises at least one of compressively strained silicon and germanium.

25. The method of claim 24, wherein the thickness of the proximal portion is in a range of 4 nm to 10 nm.

26. The method of claim 21, further comprising forming the at least one p-channel component, and forming at least one n-channel component, the at least one p-channel component and the at least one n-channel each having the channel layer in contact with a dielectric layer.

**Patentansprüche**

1. Halbleiterbasierte Vorrichtung, umfassend:

   ein Substrat, und
   eine Kanalschicht (410), die über dem Substrat liegt und in Kontakt mit diesem steht, und die von wenigstens einer p-Kanalkomponente (300A) und wenigstens einer n-Kanalkomponente (300B) gemeinsam genutzt wird,
   einer distalen Schicht (412), um wenigstens einen Teil einer Löcherleitung für die wenigstens p-Kanalkomponente zu unterstützen, und
   einer proximalen Schicht (411), um wenigstens einen Teil eines Elektronenstroms für die wenigstens eine n-Kanalkomponente zu unterstützen, wobei die proximale Schicht in Kontakt mit der distalen Schicht steht, wobei die distale Schicht zwischen dem Substrat und der proximalen Schicht angeordnet ist, und eine Dicke aufweist, die es zulässt, dass sich eine Defektelektronenwellenfunktion ausgehend von der proximalen Schicht in die distale Schicht hinein wirksam erstreckt, um die Löcherleitung mittels der distalen Schicht zu fördern; bei der die proximale Schicht unter Zug steht.

2. Vorrichtung nach Anspruch 1, wobei die wenigstens eine p-Kanalkomponente einen p-Kanaltransistor umfasst, die wenigstens eine n-Kanalkomponente einen n-Kanaltransistor umfasst.

3. Vorrichtung nach Anspruch 2, wobei der n-Kanaltransistor und der p-Kanaltransistor einem Inverter zugeordnet sind.

4. Vorrichtung nach Anspruch 3, wobei eine Gatebreite des n-Kanaltransistors und eine Gatebreite des p-Kanaltransistors gleich sind.

5. Vorrichtung nach Anspruch 3, wobei eine Gatelänge des n-Kanaltransistors und eine Gatelänge des p-Kanaltransistors gleich sind.

6. Vorrichtung nach Anspruch 3, wobei eine Löcherbeweglichkeit des p-Kanaltransistors und eine Elektronenbeweglichkeit des n-Kanaltransistors gleich sind.

7. Vorrichtung nach Anspruch 1, wobei die Dicke der proximalen Schicht für die p-Kanalkomponente kleiner als für die n-Kanalkomponente ist.

8. Vorrichtung nach Anspruch 1, wobei die proximale Schicht aus Silicium besteht und die Dicke der proximalen Schicht in einem Bereich von 4 nm bis 10 nm liegt.

9. Vorrichtung nach Anspruch 8, wobei die Dicke der proximalen Schicht etwa 5 nm beträgt.

10. Vorrichtung nach Anspruch 8, wobei die Dicke der distalen Schicht in einem Bereich von 5 nm bis 18 nm liegt.

11. Vorrichtung nach Anspruch 1, wobei die proximale Schicht den gesamten Elektronenstrom für wenigstens eine n-Kanalkomponente unterstützt.

12. Vorrichtung nach Anspruch 1, wobei die distale Schicht wenigstens einen Teil eines Elektronenstroms für wenigstens eine n-Kanalkomponente unterstützt.

13. Vorrichtung nach Anspruch 12, wobei die Dicke der proximalen Schicht kleiner als etwa 5 nm ist.

14. Vorrichtung nach Anspruch 1, ferner mit einer dielektrischen Schicht in Kontakt mit der proximalen Schicht, wobei die proximale Schicht zwischen der dielektrischen Schicht und der distalen Schicht angeordnet ist.

15. Vorrichtung nach Anspruch 1, wobei die proximale Schicht im Wesentlichen aus Silicium besteht und die distale Schicht aus Germanium besteht.

16. Vorrichtung nach Anspruch 15, ferner mit einer relaxierten SiGi-Schicht in Kontakt mit der distalen Schicht, wobei die relaxierte SiGi-Schicht eine Germaniumkonzentration in einem Bereich von 60 Atom-% bis 85 Atom-% aufweist.

17. Vorrichtung nach Anspruch 1, wobei die proximale Schicht im Wesentlichen aus Silicium besteht und die distale Schicht aus Silicium und Germanium besteht.

18. Vorrichtung nach Anspruch 1, ferner mit einer relaxierten SiGi-Schicht in Kontakt mit der distalen Schicht, wobei die relaxierte SiGi-Schicht eine Germaniumkonzentration in einem Bereich von 30 Atom-% bis 50 Atom-% aufweist, und wobei die distale Schicht eine Germaniumkonzentration in einem Bereich von 55 Atom-% bis 85 Atom-% aufweist.

19. Vorrichtung nach Anspruch 1, wobei die distale Schicht unter Druck steht.

20. Vorrichtung nach Anspruch 19, ferner mit einer relaxierten SiGi-Schicht in Kontakt mit der distalen Schicht, wobei die distale Schicht eine größere Germaniumkonzentration als eine Germaniumkonzentration in der relaxierten SiGi-Schicht hat.

**21.** Verfahren zur Herstellung einer halbleiterbasierten Vorrichtung, wobei das Verfahren umfasst:

Bereitstellen eines distalen Teils (422) einer Kanalschicht (410) auf einem Substrat (430), um eine Löcherleitung für wenigstens eine p-Kanalkomponente (300A) zu unterstützen; und

Bereitstellen eines proximalen Teils (411) der Kanalschicht (410), wobei der proximale Teil (411) zwischen dem Substrat (430) und dem proximalen Teil (411) in Kontakt mit dem distalen Teil (412) der Kanalschicht (410) steht und eine Dicke aufweist, die es ermöglicht, dass sich eine Defektelektronenwellenfunktion ausgehend von dem proximalen Teil (411) in den distalen Teil (412) hinein wirksam erstreckt, um die Löcherleitung mittels des distalen Teils zu fördern;

bei dem die Kanalschicht (410) von der wenigstens einen p-Kanalkomponente (300A) und der wenigstens einen n-Kanalkomponente (300B) gemeinsam genutzt wird, und bei dem der proximale Teil (411) unter Zug steht.

**22.** Verfahren nach Anspruch 21, wobei das Bereitstellen des proximalen Teils umfasst, den proximalen Teil an einer Stelle der wenigstens einen p-Kanalkomponente zu verkleinern, um die Unterstützung der Löcherleitung zu verbessern.

**23.** Verfahren nach Anspruch 22, wobei das Verkleinern umfasst, die Dicke des proximalen Teils an der Stelle der wenigstens p-Kanalkomponente zu verringern, wohingegen die Dicke an einer Stelle wenigstens einer n-Kanalkomponente unverändert beibehalten wird.

**24.** Verfahren nach Anspruch 21, ferner umfassend, eine Substratschicht mit Silizium und Germanium bereitzustellen, und wobei der proximale Teil unter Zug stehendes Silizium umfasst und der distale Teil unter Druck stehendes Silizium und/oder Germanium umfasst.

**25.** Verfahren nach Anspruch 24, wobei die Dicke des proximalen Teils in einem Bereich von 4 nm bis 10 nm liegt.

**26.** Verfahren nach Anspruch 21, ferner umfassend, die wenigstens eine p-Kanalkomponente auszubilden und wenigstens eine n-Kanalkomponente auszubilden, wobei die wenigstens eine p-Kanalkomponente und die wenigstens n-Kanalkomponente jeweils die Kanalschicht aufweisen, die in Kontakt mit einer dielektrischen Schicht steht.

**Revendications**

**1.** Dispositif à base de semi-conducteurs, comprenant :

un substrat, et
une couche de canal (410) qui recouvre et qui est en contact avec le substrat, et qui est partagée par au moins un composant à canal p (300A) et au moins un composant à canal n (300B), comprenant :

une couche distale (412) pour supporter au moins une partie de conduction par trous pour ledit au moins un composant à canal p ; et
une couche proximale (411) pour supporter au moins une partie d'un courant d'électrons pour ledit au moins un composant à canal n, la couche proximale étant en contact avec la couche distale, la couche distale étant située entre le substrat et la couche proximale, et ayant une épaisseur qui permet à une fonction d'onde des trous de s'étendre efficacement de la couche proximale dans la couche distale pour faciliter la conduction par trous par la couche distale ;

dans lequel la couche proximale est sous une contrainte de tension.

**2.** Dispositif selon la revendication 1, dans lequel ledit au moins un composant à canal p comprend un transistor à canal p, ledit au moins un composant à canal n comprend un transistor à canal n.

**3.** Dispositif selon la revendication 2, dans lequel le transistor à canal n et le transistor à canal p sont associés à un inverseur.

**4.** Dispositif selon la revendication 3, dans lequel une largeur de grille du transistor à canal n et une largeur de grille du transistor à canal p sont identiques.

**5.** Dispositif selon la revendication 3, dans lequel une longueur de grille du transistor à canal n et une longueur de grille du transistor à canal p sont identiques.

**6.** Dispositif selon la revendication 3, dans lequel une mobilité des trous du transistor à canal p et une mobilité des électrons du transistor à canal n sont identiques.

**7.** Dispositif selon la revendication 1, dans lequel l'épaisseur de la couche proximale est plus petite pour le composant à canal p que pour le composant à canal n.

**8.** Dispositif selon la revendication 1, dans lequel la couche proximale consiste en du silicium, et l'épaisseur de la couche proximale est dans une plage de 4 nm à 10 nm.

**9.** Dispositif selon la revendication 8, dans lequel l'épaisseur de la couche proximale est d'environ 5 nm.

**10.** Dispositif selon la revendication 8, dans lequel l'épaisseur de la couche distale est dans une plage de 5 nm à 18 nm.

**11.** Dispositif selon la revendication 1, dans lequel la couche proximale supporte la totalité d'un courant d'électrons pour au moins un composant à canal n.

**12.** Dispositif selon la revendication 1, dans lequel la couche distale supporte au moins une partie d'un courant d'électrons pour au moins un composant à canal n.

**13.** Dispositif selon la revendication 12, dans lequel l'épaisseur de la couche proximale est inférieure à environ 5 nm.

**14.** Dispositif selon la revendication 1, comprenant en outre une couche diélectrique en contact avec la couche proximale, la couche proximale étant située entre la couche diélectrique et la couche distale.

**15.** Dispositif selon la revendication 1, dans lequel la couche proximale consiste essentiellement en du silicium, et la couche distale consiste en du germanium.

**16.** Dispositif selon la revendication 15, comprenant en outre une couche de SiGe relaxé en contact avec la couche distale, la couche de SiGe relaxé ayant une concentration de germanium dans une plage de pourcentage atomique de 60 % à 85 %.

**17.** Dispositif selon la revendication 1, dans lequel la couche proximale consiste essentiellement en du silicium, et la couche distale consiste en du silicium et du germanium.

**18.** Dispositif selon la revendication 1, comprenant en outre une couche de SiGe relaxé en contact avec la couche distale, la couche de SiGe relaxé ayant une concentration de germanium dans une plage de pourcentage atomique de 30 % à 50 %, et dans lequel la couche distale a une concentration de germanium dans une plage de pourcentage atomique de 55 % à 85 %.

**19.** Dispositif selon la revendication 1, dans lequel la couche distale est sous une contrainte de compression.

**20.** Dispositif selon la revendication 19, comprenant en outre une couche de SiGe relaxé en contact avec la couche distale, dans lequel la couche distale a une concentration de germanium supérieure à une concentration de germanium dans la couche de SiGe relaxé.

**21.** Procédé pour fabriquer un dispositif à base de semi-conducteurs, le procédé consistant à :

prévoir sur un substrat (430) une partie distale (412) d'une couche de canal (410) pour supporter une conduction par trous pour au moins un composant à canal p (300A) ; et
prévoir une partie proximale (411) de la couche de canal (410), la partie proximale (411) étant en contact avec la partie distale (412) de la couche de canal (410) entre le substrat (430) et la partie proximale (411), et ayant une épaisseur qui permet à une fonction d'onde des trous de s'étendre efficacement de la partie proximale (411) dans la partie distale (412) pour faciliter la conduction par trous par la partie distale ;

dans lequel la couche de canal (410) est partagée par ledit au moins un composant à canal p (300A) et ledit au moins un composant à canal n (300B), et dans lequel la partie proximale (411) est sous une contrainte de tension.

**22.** Procédé selon la revendication 21, dans lequel la prévision de la partie proximale comprend l'amincissement de la partie proximale à un emplacement dudit au moins un composant à canal p pour améliorer la prise en charge de la conduction par trous.

**23.** Procédé selon la revendication 22, dans lequel l'amincissement comprend la réduction de l'épaisseur de la partie proximale à l'emplacement dudit au moins un composant à canal p tout en laissant l'épaisseur inchangée à un emplacement dudit au moins un composant à canal n.

**24.** Procédé selon la revendication 21, comprenant en outre la prévision d'une couche de substrat comprenant du silicium et du germanium, et dans lequel la partie proximale comprend du silicium contraint par tension, et la partie distale comprend au moins l'un du silicium et du germanium contraints par compression.

**25.** Procédé selon la revendication 24, dans lequel l'épaisseur de la partie proximale est dans une plage de 4 nm à 10 nm.

**26.** Procédé selon la revendication 21, comprenant en outre la formation dudit au moins un composant à canal p, et la formation d'au moins un composant à canal n, ledit au moins un composant à canal p et ledit au moins un composant à canal n ayant chacun la couche de canal en contact avec une couche diélectrique.

FIG. 1

NmoS

Tensile Si
Channel

Electron in
Tensile Channel

Relaxed $Si_{1x}Ge_x$

Gate
Dielectric

Compressive $Si_{1-y}Ge_y$ Channel

FIG. 2A

PMOS

Compressive $Si_{1-y}Ge_y$ Channel

Gate
Dielectric

Relaxed $Si_{1x}Ge_x$

Hole in Si and $Si_{1-y}Ge_y$
Channel

FIG. 2B

300

352

350 {

METAL 362

Poly silicon 351

320

Tensile Si 311

Compressive $Si_{1-y}Ge_y$ 312

Silicide/Germanosilicide
Contact for Source-Drain

340

340

Uniform, Relaxed $Si_{1-x}Ge_x$

330

360

FIG. 3

400

PMOS    NMOS

300 A    300 B

FIG. 4

FIG. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 31118801 P

**Non-patent literature cited in the description**

- **Yee-Chia Yeo ; Qiang Lu ; Tsu-Jae King ; Chen-ming Hu ; Kawashima T. ; Mashiro S. ; Sakai J.** Enhanced performance in sub-100 nm CMOSFETs using strained epitaxial silicon-germanium. *Electron Devices Meeting, 2000. IEDM Technical Digest,* 10 December 2000

- **Mizuno T. et al.** Advanced SOI-MOSFETs with strained Si channel for high speed CMOS electron/hole mobility enhancement. *2000 Symposium on VLSI technology,* 13 June 2000